# EUROPEAN PATENT APPLICATION

(11) **EP 1 959 157 A1**
(43) Date of publication of application: **20.08.2008**
(21) Application number: 06833698.1
(22) Date of filing: 30.11.2006
(51) Int. Cl.: F16F 15/02, C22C 27/04, H01L 21/027

(54) **MASS BODY FOR CONTROLLING VIBRATION**

(30) Priority: 09.12.2005 JP 2005356979
(71) Applicant: A.L.M.T. CORP., Tokyo 105-0014 (JP)
(72) Inventor: UMEMOTO, Satoshi, Hyogo 664-0016 (JP); KIKUHARA, Shinji, Hyogo 664-0016 (JP); INOUE, Hitoshi, Hyogo 664-0016 (JP); UENISHI, Noboru, Hyogo 664-0016 (JP)
(74) Representative: Cross, Rupert Edward Blount
(86) International application number: PCT/JP2006/323895
(87) International publication number: WO 2007/066560

(57) **Abstract**

Provided is a vibration control mass body, as a mass body used for controlling with a high accuracy a vibration associated with high-speed movement of a movable body such as a stage, which is large-sized and to which a complicated shape can be imparted. The vibration control mass body (100) includes a plurality of platy members (10, 20). The plurality of members (10, 20) are respectively made of a tungsten alloy. The tungsten alloy contains, as a chief ingredient, tungsten of greater than or equal to 80 % by mass and less than or equal to 99 % by mass. The vibration control mass body (100) is used in a staging unit having a movable body in order to control a vibration associated with movement of the movable body.

## Description

### TECHNICAL FIELD

The present invention relates generally to vibration control mass bodies and, more particularly, to a vibration control mass body which is incorporated in a staging unit, having a movable body, such as an exposure apparatus used for manufacturing a device such as a semiconductor device and a flat panel display.

### BACKGROUND ART

Conventionally, for example, in an exposure process as a process of manufacturing semiconductor devices, a pattern is printed by moving at a high speed and a high accuracy a movable body (a reticle stage or a wafer stage) which moves while holding a mask or a substrate. In order to control a vibration associated with movement of the movable body, a mass body is used.

For example, Japanese Patent Application Laid-Open Publication No. 2005-30486 (Patent Document 1) has disclosed an exposure apparatus which includes a mass damper as a vibration control apparatus in a wafer stage. This mass damper has a vibration system in which a mass body and an elastic body are connected. It is exemplarily described that as a material of the mass body, a material, having a large specific gravity, such as tungsten and lead is used.

In addition, for example, Japanese Patent Application Laid-Open Publication No. 2005-72152 (Patent Document 2) has disclosed an exposure apparatus which includes a mass damper as a vibration control apparatus in a wafer stage. This mass damper has a first vibration system in which a mass body and an elastic body are connected to make a coupled vibration in a first direction and a second vibration system in which the same mass body and a second elastic body are connected to make a coupled vibration in a second direction which is different from the first direction.

Japanese Patent Application Laid-Open Publication No. 7-150285 (Patent Document 3) has disclosed a corrosion-resistant tungsten-base sintered alloy which is used as an inertial body of an oscillator used in a small-sized vibration generator and a manufacturing method thereof.
Patent Document 1: Japanese Patent Application Laid-Open Publication No. 2005-30486
Patent Document 2: Japanese Patent Application Laid-Open Publication No. 2005-72152
Patent Document 3: Japanese Patent Application Laid-Open Publication No. 7-150285

### DISCLOSURE OF THE INVENTION

### Problems to be solved by the invention

In recent years, accompanied by an increase in a wafer size, a stage size of the above-mentioned exposure apparatus has been required to be large-sized. For this reason, the mass body for controlling the vibration associated with the movement of the stage has also been required to be large-sized.

Moreover, not only the increase in the stage size but also a compact size of a configuration of the apparatus has been required. In order to meet this requirement, it has been required that a complicated shape is impaired to the mass body.

However, it is difficult to manufacture a mass body as one component which is capable of controlling at a high accuracy a vibration associated with high-speed movement of the movable body such as the stage in the staging unit of the exposure apparatus or the like and is large-sized, and to which a complicated shape can be imparted.

Therefore, an object of the present invention is to provide a vibration control mass body, as a mass body which is used for controlling at a high accuracy a vibration associated with high-speed movement of a movable body such as a stage in a staging unit of an exposure apparatus or the like, which is large-sized and to which a complicated shape can be imparted.

### Means for solving the problems

A vibration control mass body according to the present invention comprises a plurality of members which are respectively made of a tungsten alloy containing, as a chief ingredient, tungsten of greater than or equal to 80 % by mass and less than or equal to 99 % by mass.

It is preferable that in the vibration control mass body according to the present invention, the tungsten alloy contains nickel of more than 0 % by mass and less than or equal to 18 % by mass; at least one kind of metal selected from the group consisting of iron, copper, and cobalt; and an inevitable impurity.

It is preferable that in the vibration control mass body according to the present invention, the tungsten alloy contains tungsten of greater than or equal to 90 % by mass and less than or equal to 98 % by mass and has a specific gravity of greater than or equal to 17.0 g/cm³.

Further, it is preferable that the vibration control mass body according to the present invention has a recess.

It is preferable that the vibration control mass body according to the present invention is movable, the plurality of members includes a plurality of jointed platy members, and joint surfaces of the plurality of platy members are substantially perpendicular to a direction in which the vibration control mass body moves.

In this case, it is preferable that the platy members have recesses.

It is preferable that in the vibration control mass body according to the present invention, the plurality of members are fastened by screws. In this case, although the screws themselves may be formed by a tungsten alloy, in order to enhance shock resistance and to reduce a cost, metal or an alloy, such as molybdenum and stainless steel, having a smaller specific gravity than that of the tungsten alloy is to be used for forming the screws. This reduces an apparent density of the vibration control mass body as a whole, that is, a value obtained by dividing a mass of the vibration control mass body as a whole by a volume of a shape defined by external surfaces. If the number of members is increased or the number of screws is increased beyond necessity, this apparent density is likely to be greatly reduced. Although the apparent density can be increased by excessively decreasing the number of screws, stiffness of the vibration control mass body is likely to be insufficient. When these factors are taken into consideration, a preferable range of the apparent density is greater than or equal to 16.5 g/cm³ and less than or equal to 18.8 g/cm³. In view of enhancement of the apparent density, it is preferable that the screws are made of metal or an alloy having a density of greater than or equal to 10 g/cm³ and in view of enhancement of stiffness, the screws are made of metal or an alloy having a tensile strength of greater than or equal to 400 N/mm².

In this case, it is preferable that the vibration control mass body is movable and directions in which the screws travel are substantially parallel to the direction in which the vibration control mass body moves. Here, the directions in which the screws travel are directions in which the screws move when the screws are tightened in order to joint the plurality of members which the vibration control mass body comprises, or directions in which the screws move when the screws are loosened in order to separate the plurality of members which the vibration control mass body comprises.

It is preferable that in the vibration control mass body according to the present invention, the plurality of members are diffusion-jointed.

It is preferable that in the vibration control mass body according to the present invention, the plurality of members are brazing-jointed.

It is preferable that in the vibration control mass body according to the present invention, the plurality of members are jointed by using an adhesive.

It is preferable that the vibration control mass body according to the present invention further comprises a container for accommodating the plurality of members and the container is made of a material different from a tungsten alloy.

It is preferable that the vibration control mass body according to the present invention is used in a staging unit having a movable body in order to control a vibration associated with movement of the movable body.

In this case, it is preferable that the movable body moves while holding one of a mask and a substrate and the staging unit is an exposure apparatus.

In this case, it is preferable that the vibration control mass body has a connecting member for connecting to a staging unit and a thickness of the connecting member is greater than or equal to 5 mm and less than or equal to 50 mm. A material of the connecting member may be any one which is required in the vibration control mass body according to the present invention and may be the same as or different from that of the other parts of the vibration control mass body.

### EFFECT OF THE INVENTION

According to the present invention, since the vibration control mass body comprises the plurality of members, a large-sized vibration control mass body as a whole can be produced by combining relatively small members. In addition, the plurality of members are respectively made of a tungsten alloy and it is easier to machine the tungsten alloy than metal tungsten, thereby allowing machining so as to have a complicated shape such as a shape having a recess or the like. Moreover, since the vibration control mass body has the plurality of members combined therein, even if one tungsten alloy is substantially simple rectangular parallelepiped-shaped, a complicated shape having a recess, as a shape of the whole obtained by combining the plurality of members, can be easily formed. Furthermore, since the tungsten alloy contains, as a chief ingredient, tungsten of greater than or equal to 80 % by mass and less than or equal to 99 % by mass, the vibration control mass body having a high specific gravity and a high stiffness can be obtained.

### BRIEF DESCRIPTION OF THE DRAWINGS

Fig. 1 is a schematic perspective view illustrating one embodiment as a shape of the vibration control mass body of the present invention as a whole.
Fig. 2 is a schematic perspective view illustrating one embodiment of a vibration control mass body comprising a plurality of divided members.
Fig. 3 is a schematic perspective view illustrating another embodiment of a vibration control mass body comprising a plurality of divided members.
Fig. 4 is a schematic perspective view illustrating further another embodiment of a vibration control mass body comprising a plurality of divided members.
Fig. 5 is a partially sectional view illustrating one embodiment of a configuration in which the vibration control mass body of the present invention and components of a staging unit are connected.
Fig. 6 shows a partially sectional view (A) and a bottom view (B) illustrating another embodiment of a configuration in which the vibration control mass body of the present invention and components of a staging unit are connected.
Fig. 7 shows a partially sectional view (A) and a bottom view (B) illustrating further another embodiment of a configuration in which the vibration control mass body of the present invention and components of a staging unit are connected.
Fig. 8 shows a partially sectional view (A) and a bottom view (B) illustrating still another embodiment of a configuration in which the vibration control mass body of the present invention and components of a staging unit are connected.
Fig. 9 is a schematic perspective view illustrating still another embodiment of a vibration control mass body comprising a plurality of divided members.

### EXPLANATION OF REFERENCE NUMERALS

10, 20: platy member, 11, 21, 110: recess, 12, 22: hooked portion, 13, 23, 31, 220: screw, 14, 24, 32: joint surface, 30: cylindrical container, 40, 50, 60, 70, 100, 200: vibration control mass body, 41, 51, 61, 71: vibration control mass body main body section, 42, 52, 63, 64, 73, 74, 75: connecting screw, 62, 72: connecting member, 501: linear guide, 502: rail.

### BEST MODE FOR CARRYING OUT THE INVENTION

In order to obtain a vibration control mass body, used for controlling at a high accuracy a vibration associated with high-speed movement of a movable body such as a stage included in a staging unit of an exposure apparatus or the like, which can be large-sized and to which a complicated shape can be imparted, and which has a relatively high specific gravity and a high stiffness, the present inventors studied as follows.

Conventionally, as a material of an inertial body of an oscillator used in a small-sized vibration generator, a tungsten-base sintered alloy has been used. However, when one large-sized tungsten-base sintered alloy is produced, because uneven sintering in a sintering process is conducted, a porosity is partially generated. In addition, it is not practical to produce one large-sized tungsten-base sintered alloy in view of a manufacturing cost and a production capability.

Based on the above-mentioned examination, the present inventors have devoted themselves to studies, focusing attention on characteristics which are required of the vibration control mass body. As a result, the present inventors have found that when the vibration control mass body is divided into a plurality of members and the plurality of members are formed by using a tungsten alloy, the above-mentioned required characteristics can be attained. Based on such findings obtained by the present inventors, the present invention was made.

The vibration control mass body of the present invention comprises a plurality of members which are respectively made of a tungsten alloy containing, as a chief ingredient, tungsten of greater than or equal to 80 % by mass and less than or equal to 99 % by mass. The vibration control mass body having such a configuration, which is manufactured in a manner in which a plurality of pieces of the tungsten alloy are manufactured and combined, can be large-sized as a whole. A complicated shape can be imparted to the vibration control mass body having such a configuration since it is easier to machine the tungsten alloy than metal tungsten. Since the vibration control mass body has the plurality of members combined therein, even if one tungsten alloy is substantially simple rectangular parallelepiped-shaped, a complicated shape having recesses, as a shape of the whole obtained by combining the plurality of members, can be easily formed. It is made possible to obtain the vibration control mass body having a high specific gravity and a high stiffness. If a content of the tungsten exceeds 99 % by mass, because properties thereof are close to pure tungsten and therefore, the tungsten alloy becomes rigid and brittle, it is impossible to obtain the vibration control mass body having the high stiffness.

It is preferable that a volume of one member is greater than or equal to 540 cm³ and less than or equal to 2700 cm³ and a weight of one member is greater than or equal to 10 kg and less than or equal to 50 kg. If the volume of one member is greater than 2700 cm³ and the weight of one member is greater than 50 kg, because the weight of the members are heavy, it is difficult to handle the members. If the volume of one member is less than 540 cm³ and the weight of one member is less than 10 kg, because a cumulative tolerance is increased due to an increase in the number of components, a dimensional accuracy of the vibration control mass body as a whole is worsened.

It is preferable that a volume of the vibration control mass body as a whole is greater than or equal to 2700 cm³ and less than or equal to 54000 cm³ and a weight of the vibration control mass body as a whole is greater than or equal to 50 kg and less than or equal to 1000 kg. If the volume and the weight of the vibration control mass body as a whole are less than the above-mentioned lower limits, a cost is likely to be rather increased by forming the vibration control mass body so as to comprise the plurality of members. If the volume and the weight of the vibration control mass body as a whole exceed the above-mentioned upper limits, a dimensional accuracy is likely to be worsened due to an increase in the number of components.

It is preferable that the tungsten alloy of the vibration control mass body of the present invention contains nickel of more than 0 % by mass and less than or equal to 18 % by mass; at least one kind of metal selected from the group consisting of iron, copper, and cobalt; and an inevitable impurity.

In addition, it is preferable that the tungsten alloy of the vibration control mass body of the present invention contains the tungsten of greater than or equal to 90 % by mass and less than or equal to 98 % by mass and has a specific gravity of greater than or equal to 17.0 g/cm³. It is preferable that the tungsten alloy contains nickel; at least one kind of metal selected from the group consisting of iron, copper, and cobalt; and an inevitable impurity, and a total content of these is greater than or equal to 2 % by mass and less than or equal to 10 % by mass. Through forming the plurality of members using the tungsten alloy which contains the tungsten of greater than or equal to 90 % by mass, the specific gravity can be increased and an efficiency of decreasing vibration energy can be enhanced. In addition, through containing the tungsten of less than or equal to 98 % by mass, the degree of sintering of the tungsten alloy can be heightened. These features allows the vibration control mass body to be compact. Note that to the extent that the effects of the present invention are not impaired, the tungsten alloy in the present invention may contain elements other than nickel, iron, copper, and cobalt, and for example, may contain manganese, molybdenum, silicon, rhenium, chromium, titanium, vanadium, niobium, tantalum, etc.

Further preferably, a mass ratio of nickel to a remainder except the tungsten and the nickel is 5 : 5 to 9 : 1. Such composition allows the degree of sintering of the tungsten alloy to be further heightened and makes the formation of a sintered body easy.

It is most preferable that the tungsten alloy has composition of the following ranges: 95 to 98 % by mass of the tungsten; 1 to 4.5 % by mass of the nickel; and 0.2 to 2.5 % by mass of the iron, with the remainder being an inevitable impurity. Such composition allows manufacturing the tungsten alloy having a high specific gravity and a high strength at a high degree of sintering. Note that a part or all of the iron in the above-mentioned composition range may be replaced with cobalt. In such a case, corrosion resistance can be imparted to the tungsten alloy.

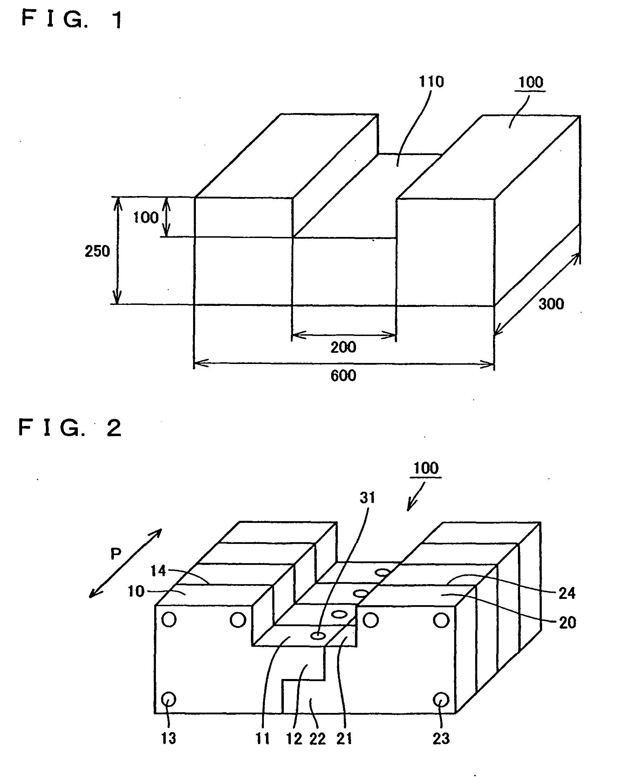

Fig. 1 is a schematic perspective view illustrating one embodiment as a shape of the vibration control mass body of the present invention as a whole. In Fig. 1, numerals indicate exemplary dimensions (mm) of respective parts.

As shown in Fig. 1, a vibration control mass body 100 has a recess 110. Through forming the vibration control mass body 100 so as to have such a configuration, a peripheral unit such as a linear motor, as a driving source for moving a movable body included in a staging unit, can be disposed in the recess 110 of the vibration control mass body 100, thereby allowing a configuration of the staging unit to be compact. Note that screw holes may be formed in the vibration control mass body 100. By using the screw holes, the vibration control mass body 100 can be attached on a movable body such as a stage. Note that a plurality of recesses may be provided in the vibration control mass body 100.

Fig. 2 is a schematic perspective view illustrating one embodiment of a vibration control mass body comprising a plurality of divided members.

As shown in Fig. 2, the vibration control mass body 100 is movable in a direction indicated by an arrow P. The vibration control mass body 100 includes a plurality of jointed platy members 10 and 20. The platy members 10 and 20 are made of the tungsten alloy. The platy members 10 and 20 have hooked portions 12 and 22 which can engage with each other. A plurality of platy members 10 are aligned in the direction indicated by the arrow P and jointed. Accordingly, joint surfaces 14 of the plurality of platy members 10 are substantially perpendicular to the direction P in which the vibration control mass body 100 moves. Also the plurality of platy members 20 are aligned in the direction indicated by the arrow P and jointed. Accordingly, joint surfaces 24 of the plurality of platy members 20 are substantially perpendicular to the direction P in which the vibration control mass body 100 moves. By disposing the joint surfaces 14 and 24, as described above, so as to be substantially perpendicular to the direction P in which the vibration control mass body 100 moves, shearing stresses exerted on the joint surfaces 14 and 24 can be reduced and a stiffness of the vibration control mass body 100 as a whole which comprises the plurality of platy members 10 and 20 can be enhanced.

In this case, the platy members 10 have recesses 11 and the platy members 20 have recesses 21. The platy members 10 and 20 are made of the tungsten alloy. Since it is easier to machine the tungsten alloy than pure tungsten, complicated shapes of the recesses 11 and 21, the hooked portions 12 and 22 having projections and depressions, and the like can be easily imparted. By forming the platy members 10 and 20, which can engage with each other, so as to have the projections and depressions, positional accuracies obtained when engaging with each other can be improved. Note that it is preferable that as machining accuracies of the engaged surfaces, a flatness is less than 0.05 mm and a surface roughness Ra is less than 6.3 µ m.

The plurality of members 10 of the vibration control mass body 100 are fastened by screws 13 with one another, the plurality of members 20 of the vibration control mass body 100 are fastened by screws 23 with one another, and the plurality of members 10 and 20 are respectively fastened by screws 31 with each other. By fastening the plurality of members 10 and 20 with the screws as described above, the vibration control mass body 100 as a whole having a complicated shape can be easily formed at a low cost.

In this case, the vibration control mass body 100 is movable; and the direction indicated by the arrow P in which the vibration control mass body 100 moves is substantially parallel to a direction in which each of the screws 13 and 23 moves when the screws 13 and 23 are tightened in order to joint the plurality of members 10 and 20 which the vibration control mass body 100 comprises, or to a direction in which each of the screws 13 and 23 moves when the screws 13 and 23 are loosened in order to separate the plurality of members 10 and 20 which the vibration control mass body 100 comprises, that is, a direction in which each of the screws 13 and 23 travels. The above-described configuration allows shearing stresses to be reduced and a stiffness of the vibration control mass body 100 as a whole, which comprises the plurality of platy members 10 and 20, to be enhanced.

In addition, when screws made of metal or an alloy having a density of greater than or equal to 10 g/cm³ are used to joint the tungsten alloys with one another, a ratio of a relative reduction in a specific gravity of the vibration control mass body 100 as a whole can be made smaller. Specifically, as a material of the screws, molybdenum, an tungsten alloy, a molybdenum alloy, etc. which each have a relatively high specific gravity and favorable machinability can be cited.

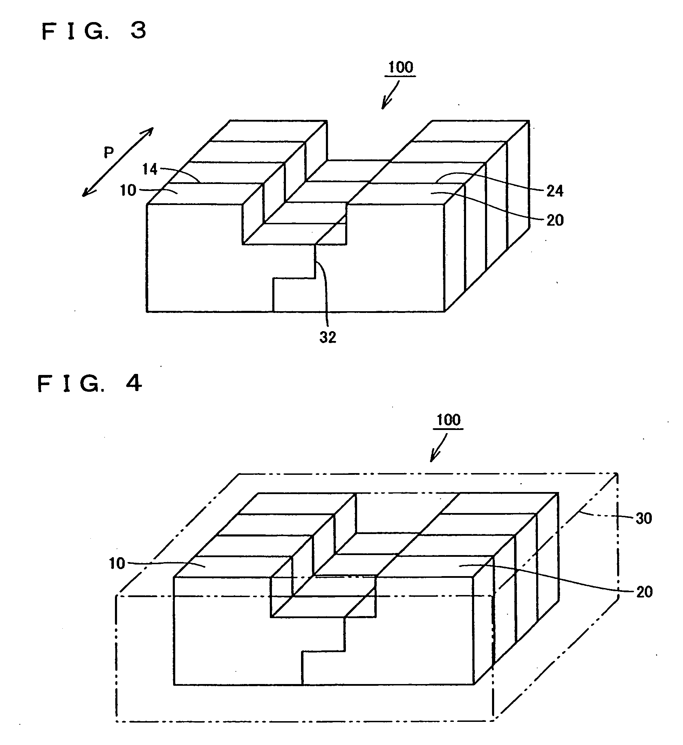

Fig. 3 is a schematic perspective view illustrating another embodiment of a vibration control mass body comprising a plurality of divided members.

In a vibration control mass body 100 shown in Fig. 3, unlike in the vibration control mass body 100 shown in Fig. 2, the screws are not used and a plurality of members 10 are diffusion-jointed on joint surfaces 14 with one another, a plurality of members 20 are diffusion-jointed on joint surfaces 24 with one another, and a plurality of members 10 and 20 are respectively diffusion-jointed on joint surfaces 32 with each other. The other configuration of the vibration control mass body 100 shown in Fig. 3 is the same as that of the vibration control mass body 100 shown in Fig. 2. By integrating the plurality of members 10 and 20 through the diffusion-jointing as described above, the vibration control mass body 100 as a whole having a complicated shape can be easily formed at a low cost. The diffusion-jointing is conducted through a heat treatment in a vacuum or a hydrogen gas atmosphere at a temperature of greater than or equal to 1400°C for 10 hours.

In the vibration control mass body 100 shown in Fig. 3, the plurality of members 10 may be brazed on the joint surfaces 14 with one another, the plurality of members 20 may be brazed on the joint surfaces 24 with one another, and the plurality of members 10 and 20 may be brazed respectively on the joint surfaces 32 with each other. By integrating the plurality of members 10 and 20 through the brazing-jointing as described above, the vibration control mass body 100 as a whole having a complicated shape can be easily formed at a low cost. The brazing-jointing is conducted in a manner in which the plurality of members 10 and 20 having nickel-plated surfaces are placed in a furnace at a temperature of 500 to 1000°C and silver is used as brazing filler metal.

Furthermore, in the vibration control mass body 100 shown in Fig. 3, the plurality of members 10 may be jointed on the joint surfaces 14 with one another by using an adhesive of a high molecular compound or the like, the plurality of members 20 may be jointed on the joint surfaces 24 with one another by using the adhesive of the high molecular compound or the like, and the plurality of members 10 and 20 may be jointed respectively on the joint surfaces 32 with each other by using the adhesive of the high molecular compound or the like. By integrating the plurality of members 10 and 20 through the jointing by using the adhesive as described above, the vibration control mass body 100 as a whole having a complicated shape can be easily formed at a low cost. It is preferable to use an adhesive which produces no organic gas.

Fig. 4 is a schematic perspective view illustrating further another embodiment of a vibration control mass body comprising a plurality of divided members.

As shown in Fig. 4, a vibration control mass body 100 further comprises a container 30 for accommodating a plurality of members 10 and 20. The container 30 is made of a material different from the tungsten alloy. The vibration control mass body 100 shown in Fig. 4 has the same configuration as that of the vibration control mass body 100 shown in Fig. 2 except that the plurality of members 10 and 20 are respectively not jointed with each other. Since the plurality of members 10 and 20 are not directly jointed and integrated by being accommodated in the container 30 as described above, preprocessing, such as screw hole tapping and plating processing, for jointing the plurality of members 10 and 20 can be omitted, whereby the vibration control mass body 100 as a whole having a complicated shape can be easily formed at a low cost.

The vibration control mass body 100 of the present invention is used in a staging unit having a movable body in order to control a vibration associated with movement of the movable body. The present invention allows manufacturing at a low cost a compact moving stage or the like which holds a large-sized substrate.

In this case, it is preferable that the movable body moves while holding a mask or a substrate and the staging unit is an exposure apparatus. In particular, the vibration control mass body 100 of the present invention is applied to an exposure apparatus used in a process of manufacturing semiconductor devices, an exposure apparatus used in a process of manufacturing plasma displays, or the like, whereby the above-mentioned effects can be further exhibited.

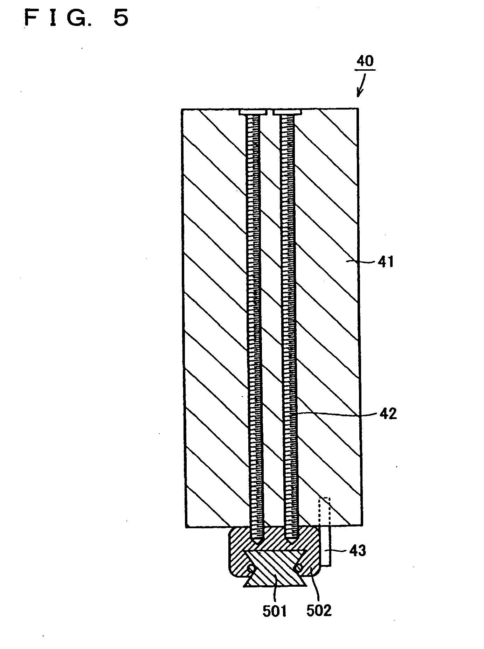

Fig. 5 is a partially sectional view illustrating one embodiment of a configuration in which the vibration control mass body of the present invention and components of a staging unit are connected.

As shown in Fig. 5, a vibration control mass body 40 is connected to a linear guide 502 as a component of a staging unit. The linear guide 502 moves along a rail 501 attached on a main body of the staging unit. Accordingly, the vibration control mass body 40 attached on a movable body moves along the rail 501 via the linear guide 502.

In this case, in order for the vibration control mass body 40 to be attached on the linear guide 502, it is required that long screw holes are formed on a vibration control mass body main body section 41 and the vibration control mass body main body section 41 is fastened on the linear guide 502 by inserting connecting screws 42 into the long screw holes. At this time, because of the presence of the screw holes and the connecting screws 42, a specific gravity of the vibration control mass body 40 as a whole is relatively reduced. Note that in this case, in order to align the linear guide 502 with the vibration control mass body main body section 41, it is required that a pin 43 is fixed on the vibration control mass body main body section 41.

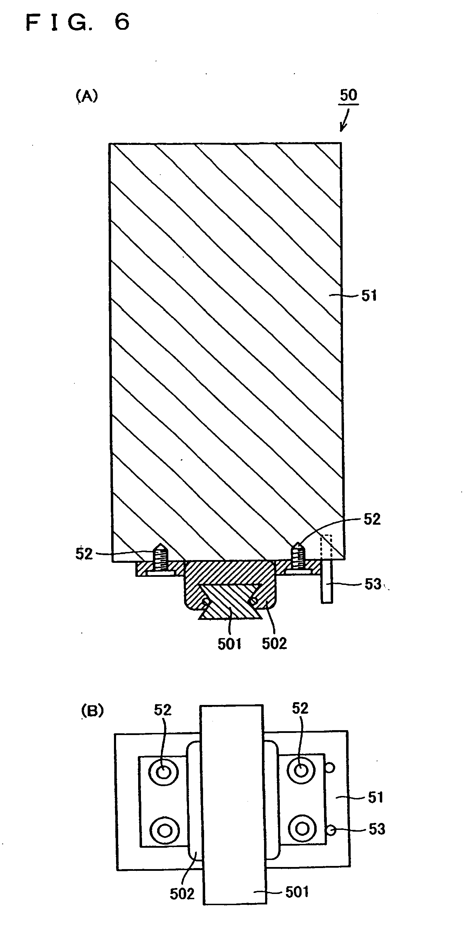

Fig. 6 shows a partially sectional view (A) and a bottom view (B) illustrating another embodiment of a configuration in which the vibration control mass body of the present invention and components of a staging unit are connected.

As shown in Fig. 6, in order to prevent a relative reduction in a specific gravity of a vibration control mass body 50 as a whole due to the presence of long screw holes and connecting screws, it is considered that a vibration control mass body main body section 51 is attached on the linear guide 502 having a flange by using four relatively short connecting screws 52. However, in this case, since it is required that a portion of the flange which the linear guide 502 has is fastened on the vibration control mass body main body section 51 by using the four connecting screws 52, an area of a bottom surface of the vibration control mass body 50 is increased by an area corresponding to that of the portion of the flange. This makes it difficult to allow the staging unit to be small-sized. Note that also in this case, in order to align the linear guide 502 with the vibration control mass body 50, it is required that two pins 53 are fixed on the vibration control mass body main body section 51.

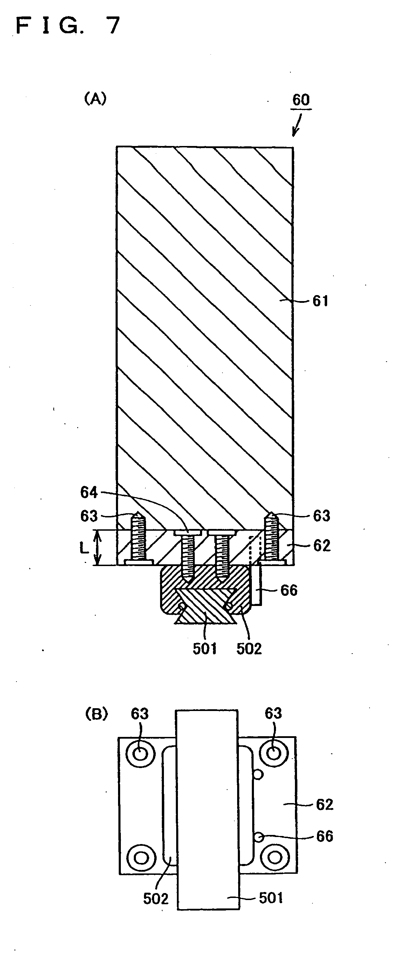

Fig. 7 shows a partially sectional view (A) and a bottom view (B) illustrating further another embodiment of a configuration in which the vibration control mass body of the present invention and components of a staging unit are connected.

As shown in Fig. 7, in order to prevent a relative reduction in a specific gravity of a vibration control mass body 60 as a whole due to the presence of screw holes and connecting screws and to avoid an excessive increase in an area of a bottom surface of the vibration control mass body 60, it is considered that a vibration control mass body main body section 61 is attached on a linear guide 502 via a connecting member 62 which is made of the same material as that of the vibration control mass body main body section 61. In this case, the vibration control mass body main body section 61 and the connecting member 62 are connected by using four relatively short connecting screws 63 and the linear guide 502 and the connecting member 62 are connected by using four relatively short connecting screws 64. Note that also in this case, in order to align the linear guide 502 with the vibration control mass body 60, it is required that two pins 66 are fixed on the connecting member 62. At this time, there accrues a problem that positions of screw holes for the pins 66 interfere with those for the connecting screws 63.

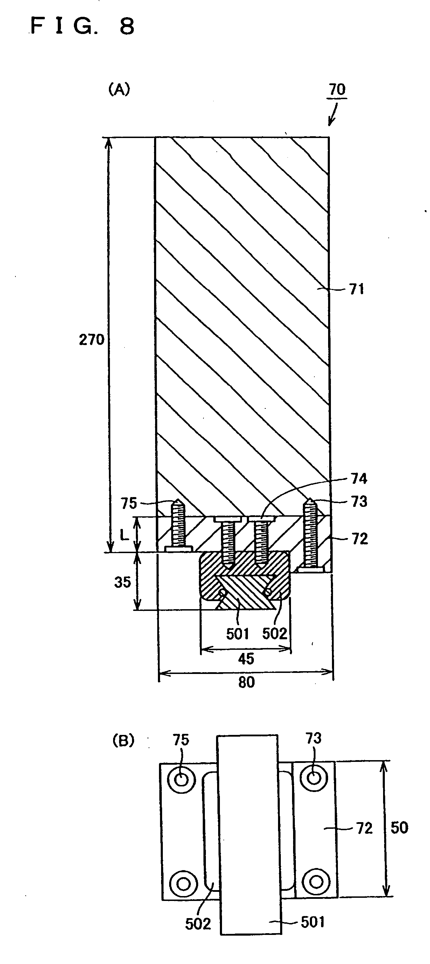

Fig. 8 shows a partially sectional view (A) and a bottom view (B) illustrating still another embodiment of a configuration in which the vibration control mass body of the present invention and components of a staging unit are connected.

As shown in Fig. 8, in order to prevent a relative reduction in a specific gravity of a vibration control mass body 70 as a whole due to the presence of screw holes and connecting screws, to avoid an excessive increase in an area of a bottom surface of the vibration control mass body 70, and to align a linear guide 502 with the vibration control mass body 70 without using pins, it is considered that a, vibration control mass body main body section 71 is attached on the linear guide 502 via an L-shaped connecting member 72 which is made of the same material as that of the vibration control mass body main body section 71. In this case, the vibration control mass body main body section 71 and the connecting member 72 are connected by using four relatively short connecting screws 73 and 75 and the linear guide 502 and the connecting member 72 are connected by using four relatively short connecting screws 74.

As described above, when the vibration control mass body of the present invention is used in a staging unit having a movable body in order to control a vibration associated with movement of the movable body, it is first required that a linear guide as a guide member is attached on the vibration control mass body. In this case, the linear guide is fastened on the vibration control mass body generally by using screws. It is required that these screws are manufactured by using a material having a high impact value in order to be capable of withstanding a shock caused when the movable body suddenly starts or stops. In other words, if the screws are made of a material like the tungsten alloy of which the vibration control mass body is made, the screws are likely to be deformed or broken. However, for example, if the screws are manufactured by using a material, such as stainless steel, having a high impact value, a specific gravity of the vibration control mass body as a whole is relatively reduced due to the presence of screw holes and connecting screws. For example, as shown in Fig. 5, when the vibration control mass body 40 is formed in an integrated manner, the lengths of the connecting screws 42 are long. This causes a mass loss of the vibration control mass body as a whole. In addition, for example, as shown in Fig. 6, when the vibration control mass body 50 is formed in an integrated manner and the lengths of the connecting screws 52 are shortened, it is required to use the linear guide 502 having the flange and therefore, an area of the bottom surface of the vibration control mass body 50 is increased by an area corresponding to that of the portion of the flange. This makes it difficult to allow the staging unit to be small-sized. Therefore, in order to prevent a relative reduction in a specific gravity of the vibration control mass body as a whole due to the presence of screw holes and connecting screws and to avoid an excessive increase in an area of the bottom surface of the vibration control mass body, as shown in Fig. 7 or Fig. 8, it is required that the vibration control mass body 61 or 71 is fastened on the linear guide 502 via the connecting member 62 or 72 by using the connecting screws 63 and 64 or the connecting screws 73, 74, and 75.

In this case, it is required that a thickness L of the connecting member 62 or 72 is minimum but allows a capability of withstanding a shock caused when the movable body suddenly starts or stops; and the mass loss of the vibration control mass body as a whole due to the presence of the screw holes and the connecting screws is reduced as much as possible and is limited to a given range in order to reduce a moment applied to the screws. In order to satisfy these conditions, it is preferable that the thickness L of the connecting member 62 or 72 is in a range of greater than or equal to 5 mm and less than or equal to 50 mm. In order to more effectively prevent the relative reduction in the specific gravity of the vibration control mass body as a whole, it is more preferable that the thickness L of the connecting member 62 or 72 is less than or equal to 35 mm.

In addition, by forming the connecting member so as to be L-shaped as shown in Fig. 8 or to be U-shaped, the connecting member can be aligned with the staging unit, that is, the linear guide 502 with ease and accuracy.

Since it is required that the connecting screws are made of a material having a high impact value in order to withstand a shock caused when the movable body suddenly starts or stops, it is preferable that stainless steel is used as the material.

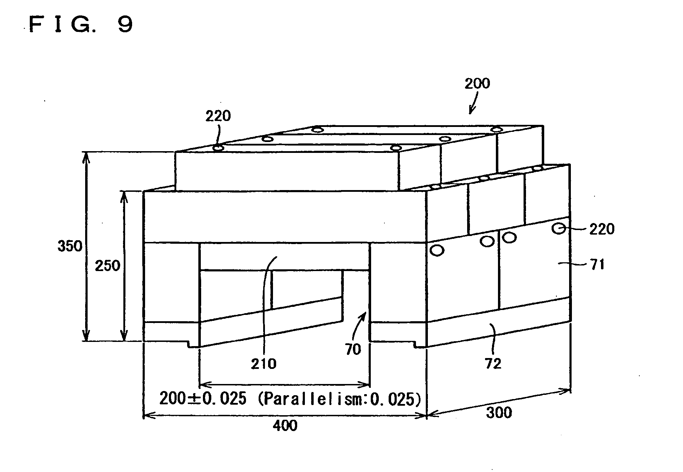

Fig. 9 is a schematic perspective view illustrating still another embodiment of a vibration control mass body comprising a plurality of members, in which the vibration control mass body 70 shown in Fig. 8 is incorporated.

As shown in Fig. 9, a vibration control mass body 200 can be made large-sized through combining a plurality of members which are substantially rectangular-parallelepiped-shaped. In Fig. 9, exemplary dimensions (mm) of respective parts are indicated. By jointing the substantially rectangular-parallelepiped-shaped members by using screws 220 in an integrated manner, the vibration control mass body 200 having a high dimensional accuracy can be easily formed at a low cost. It is preferable that a volume of each of the members, except connecting portions, is greater than or equal to 540 cm³ and less than or equal to 2700 cm³ and a weight of each of the members, except the connecting portions, is greater than or equal to 10 kg and less than or equal to 50 kg. If the volume is greater than 2700 cm³ and the weight is greater than 50 kg, a weight of the members are heavy, thereby making it difficult to handle the members. If the volume is less than 540 cm³ and the weight is less than 10 kg, a cumulative tolerance is increased by an increase in the number of the members, thereby worsening a dimensional accuracy of the vibration control mass body as a whole.

The respective members are manufactured through machining the tungsten alloy by using the conventional machine tool such as a lathe and a machining center and thereby, through conducting hole-drilling and dimensional coordination. After the machining, external surfaces of the members are polished by using a surface grinder. For example, when the vibration control mass body 200 shown in Fig. 9 is assembled, precision at a part where the dimension 200 (mm) is indicated (parallelism: 0.025, dimensional tolerance: ±0.025) is of importance. If this precision is not satisfied, a trouble arises when a linear guide is attached on the vibration control mass body 200. If an integrated object is machined, large equipment such as an electric discharge machine is needed. In the configuration shown in Fig. 9, by surface-grinding the rectangular-parallelepiped-shaped members with precision and particularly, the member 210 with high precision, the vibration control mass body as a whole having satisfied precision can be obtained when the members are assembled. In other words, in each of the members, a flatness, a perpendicularity, and a parallelism are made less than or equal to 0.01 mm, a surface roughness Ra is made less than or equal to 1.6 µm, and a hole tolerance is made less than or equal to 0.05 mm; and particularly, in the member 210, a flatness, a perpendicularity, and a parallelism are made less than or equal to 0.01 mm, and a dimensional tolerance in a longitudinal direction is made less than or equal to 5 µm, whereby the precision at the part where the dimension 200 (mm) is indicated (parallelism: 0.025, dimensional tolerance: ±0.025) shown in Fig. 9 can be attained when the vibration control mass body 200 is formed in an integrated manner.

### EXAMPLES

Hereinafter, examples of the present invention will be described.

### (Example 1)

First, a tungsten (W) powder of 97 % by mass, a nickel (Ni) powder of 2 % by mass, an iron (Fe) powder of 1 % by mass were dry-blended for 30 minutes by using a mixer. Thereafter, the above-mentioned metal mixed powder was sieved one time by using a screen mesh. The screen mesh with a Tyler mesh size #150 was used.

The #150-under mixed powder separated by sieving was subjected to cold isostatic pressing (CIP), and thereby, a compact having dimensions of 500 mm X 30 mm X 100 mm was obtained. As conditions of the cold isostatic pressing, a pressure was 1. 5 ton/cm² (pressing speed: 0.1 ton/min.) and a retention time was 60 seconds.

The obtained compact was cut by using a band saw and thereafter, surface grinding using a grinding stone and milling were conducted.

Thereafter, the processed compact was sintered in a hydrogen gas atmosphere (flow rate: 5 m³/hr) for 12 hours at a highest temperature of 1450°C.

By milling the obtained sintered body, members 10 and 20 having the dimensions shown in Fig. 1, which the vibration control mass body 100 comprises, were prepared. Screw holes into which JIS-M16 screws 13, 23, and 31 are to be inserted were formed by hole-drilling by using a machining center (MC). In each of the members 10 and 20, a flatness was less than or equal to 0.05 mm, a surface roughness Ra was less than or equal to 6.3 µm, and a hole tolerance was less than or equal to 0.05 mm.

The members 10 and 20 prepared as described above were combined and jointed by using the JIS-M16 screws 13, 23, and 31 made of a tungsten alloy. It was confirmed that even when the obtained vibration control mass body 100 was moved in the direction indicated by the arrow P at a traveling speed of 12 m/min, the members 10 and 20 were not respectively separated from each other and the integrated vibration control mass body 100 had a high stiffness.

### (Example 2)

First, a tungsten (W) powder of 97 % by mass, a nickel (Ni) powder of 2 % by mass, an iron (Fe) powder of 1 % by mass were dry-blended for 30 minutes by using a mixer. Thereafter, the above-mentioned metal mixed powder was sieved one time by using a screen mesh. The screen mesh with a Tyler mesh size #150 was used.

The #150-under mixed powder separated by sieving was subjected to cold isostatic pressing (CIP), and thereby, a compact having predetermined dimensions was obtained. As conditions of the cold isostatic pressing, a pressure was 1. 5 ton/cm² (pressing speed: 0.1 ton/min.) and a retention time was 60 seconds.

The obtained compact was cut by using a band saw and thereafter, surface grinding using a grinding stone and milling were conducted.

Thereafter, the processed compact was sintered in a hydrogen gas atmosphere (flow rate: 5 m³/hr) for 12 hours at a highest temperature of 1450°C.

By milling the obtained sintered body (specific gravity of tungsten alloy: 18.5 g/cm³), a vibration control mass body main body section 71 and a connecting member 72 which a vibration control mass body 70 having the dimensions (mm) shown in Fig. 8 comprises were prepared. Four crew holes (a nominal diameter: M8, grade: class 2) into which JIS-M8 screws 73 and 75 are to be inserted were formed on the vibration control mass body main body section 71 and eight through-holes (a hole diameter: 14 mm, a diameter of a perforation escape hole with a countersunk hole having a depth of 8 mm: 9 mm) were formed on the connecting member 72 by hole-drilling by using a machining center (MC). In each of the vibration control mass body main body section 71 and the connecting member 72, a flatness was less than or equal to 0.05 mm, a surface roughness Ra was less than or equal to 6.3 µm, and a hole tolerance was less than or equal to 0.05 mm. As the material of the connecting screws 73, 74, and 75, a JIS-SUS304 stainless steel was used. A weight of the vibration control mass body 70 obtained as described above was approximately 200 kg.

Five kinds of the vibration control mass body 70, whose dimensions L shown in Fig. 8 were respectively 3 mm, 10 mm, 30 mm, 45 mm, and 60 mm, were prepared. On each of the vibration control mass bodies 70, the linear guide 502 was attached. Each of the vibration control mass bodies 70 having the linear guide 502 attached thereon was moved at a traveling speed of 20 mm/sec along a rail 501 on a staging unit. An acceleration at the time of starting and stopping was 9.1 m/sec². With a traveling stroke of 100 mm, each of the vibration control mass bodies repeated moving and stopping under the above-mentioned conditions. At the time points at which the numbers of the repetitions were 100 cycles, 500 cycles, and 1000 cycles, the portions which were fastened by the connecting screws 73, 74, and 75 were inspected.

As a result, in the vibration control mass body 70 whose dimension L was 3 mm, at the time point at which the number of the repetitions was 100 cycles, cracking occurred in the member 72; and in the vibration control mass bodies 70 whose dimensions L were 10 mm, 30 mm, 45 mm, even at the time point at which the number of the repetitions was 1000 cycles, no abnormality was found. In the vibration control mass body 70 whose dimension L was 60 mm, at the time point at which the number of the repetitions was 500 cycles, misalignment of approximately 0.3 mm was caused between the vibration control mass body main body section 71 and the connecting member 72. It can be understood from the above-mentioned result that it is preferable that the thickness dimension L of each of the connecting member 62 and 72 is in a range of greater than or equal to 5 mm and less than or equal to 50 mm.

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

### INDUSTRIAL APPLICABILITY

The vibration control mass body according to the present invention is used by being incorporated in a staging unit, having a movable body, such as an exposure apparatus which is used for manufacturing a device such as a semiconductor device and a plasma display.

## Claims

1. A vibration control mass body (100, 200) comprising a plurality of members (10, 20, 70) which are respectively made of a tungsten alloy containing, as a chief ingredient, tungsten of greater than or equal to 80 % by mass and less than or equal to 99 % by mass.

2. The vibration control mass body (100, 200) according to claim 1, wherein the tungsten alloy contains nickel of more than 0 % by mass and less than or equal to 18 % by mass; at least one kind of metal selected from the group consisting of iron, copper, and cobalt; and an inevitable impurity.

3. The vibration control mass body (100, 200) according to claim 1, wherein the tungsten alloy contains tungsten of greater than or equal to 90 % by mass and less than or equal to 98 % by mass and has a specific gravity of greater than or equal to 17.0 g/cm³.

4. The vibration control mass body (100) according to claim 1, having a recess (110).

5. The vibration control mass body (100) according to claim 1, wherein the vibration control mass body is movable, the plurality of members includes a plurality of jointed platy members (10, 20), and joint surfaces (14, 24) of the plurality of platy members (10, 20) are substantially perpendicular to a direction (P) in which the vibration control mass body (100) moves.

6. The vibration control mass body (100) according to claim 5, wherein the platy members (10, 20) have recesses (11, 21).

7. The vibration control mass body (100, 200) according to claim 1, wherein the plurality of members (10, 20, 70) are fastened by screws (13, 23, 31,220).

8. The vibration control mass body (100) according to claim 7, wherein the vibration control mass body is movable and directions in which the screws (13,23) travel are substantially parallel to the direction (P) in which the vibration control mass body moves.

9. The vibration control mass body (100) according to claim 1, wherein the plurality of members (10, 20) are diffusion-jointed.

10. The vibration control mass body (100) according to claim 1, wherein the plurality of members (10, 20) are brazing-jointed.

11. The vibration control mass body (100) according to claim 1, wherein the plurality of members (10, 20) are jointed by using an adhesive.

12. The vibration control mass body (100) according to claim 1, further comprising a container (30) for accommodating the plurality of members (10, 20), wherein the container (30) is made of a material different from a tungsten alloy.

13. The vibration control mass body (100, 200) according to claim 1, which is used in a staging unit having a movable body in order to control a vibration associated with movement of the movable body.

14. The vibration control mass body (100, 200) according to claim 13, wherein the movable body moves while holding one of a mask and a substrate and the staging unit is an exposure apparatus.

15. The vibration control mass body (200, 60, 70) according to claim 13, having a connecting member (62, 72) for connecting to a staging unit (502), wherein a thickness of the connecting member is greater than or equal to 5 mm and less than or equal to 50 mm.
